# EUROPEAN PATENT APPLICATION

(11) **EP 4 492 682 A1**
(43) Date of publication of application: **15.01.2025**
(21) Application number: 24183553.7
(22) Date of filing: 20.06.2024
(51) Int. Cl.: H03F 1/48, H03F 1/38, H03F 1/34, H03F 3/45, H03F 3/195

(54) **AMPLIFICATION CIRCUIT, MULTI-STAGE AMPLIFIER AND AMPLIFIER**

(30) Priority: 12.07.2023 KR 20230090736; 26.09.2023 KR 20230129712
(71) Applicant: Samsung Electronics Co., Ltd., Suwon-si, Gyeonggi-do 16677 (KR)
(72) Inventor: KWON, Kibaek, 16677 Suwon-si (KR); LIM, Donghyuk, 16677 Suwon-si (KR); CHOI, Youngho, 16677 Suwon-si (KR)
(74) Representative: Marks & Clerk LLP

(57) **Abstract**

An amplification circuit (100) includes an amplifier (120) comprising an input terminal and an output terminal, a first inductor unit (110) connected to the input terminal, and a second inductor unit (130) connected to the output terminal. The first inductor unit (110) and the second inductor unit (130) may be inductively coupled to each other so that a change in output voltage of the amplification circuit (100) is positively fed back.

## Description

### BACKGROUND

Various example embodiments relate to an amplification circuit, a multi-stage amplifier, and an amplifier.

With the explosive growth of data usage, data transmission speeds across various wired and wireless communication standards are also increasing rapidly. An analog frontend (AFE) amplifier, operating at a high frequency, is required (or advantageous) to achieve high-speed data transmission. However, conventional bandwidth extension techniques have limited ability to extend the bandwidth of an amplifier.

For example, an amplifier having a bandwidth of at least 56 GHz is required (or advantageous) to comply with the 224 Gbps transmission standard of IEEE 802.3. However, conventional amplifiers have an inherent delay caused by a parasitic capacitance component of transistors, limiting their bandwidth to around 10 GHz. Even with the application of conventional bandwidth extension techniques, it may be difficult to extend the bandwidth of the amplifier to 56 GHz.

### SUMMARY

Various example embodiments provide an amplification circuit, a multi-stage amplifier, and an amplifier, which have extended bandwidth for high-speed operation.

Some example embodiments of inventive concepts provide an amplification circuit including an amplifier including an input terminal and an output terminal, a first inductor unit connected to the input terminal, and a second inductor unit connected to the output terminal. The first inductor unit and the second inductor unit may be inductively coupled to each other so that a change in output voltage of the amplification circuit is positively fed back.

Some example embodiments of inventive concepts provide a multi-stage amplifier including a plurality of amplification stages. At least one of the plurality of amplification stages may include an amplifier including an input terminal and an output terminal, a first inductor unit connected to the input terminal, and a second inductor unit connected to the output terminal. The first inductor unit and the second inductor unit may be inductively coupled to each other so that a change in output voltage of a corresponding amplification stage is positively fed back.

Some example embodiments of inventive concepts provide an amplifier including an input terminal and an output terminal. A first inductor and a second inductor, inductively coupled to each other to have mutual inductance, may be connected to the input terminal and the output terminal, respectively.

At least some of the above and other features of the invention are set out in the claims.

### BRIEF DESCRIPTION OF DRAWINGS

The above and other aspects, features, and advantages of the present inventive concepts will be more clearly understood from the following detailed description, taken in conjunction with the accompanying drawings.
FIG. 1 is a block diagram illustrating a configuration of an amplification circuit according to an example embodiment.
FIG. 2A is a diagram illustrating a coupling effect between two inductors caused by mutual inductance.
FIG. 2B is a circuit diagram illustrating an example of how to implement an amplification circuit according to an example embodiment.
FIG. 3 is a diagram illustrating a bandwidth improvement effect of an amplification circuit according to an example embodiment.
FIG. 4 is a circuit diagram illustrating an example of how to implement an amplification circuit according to an example embodiment.
FIG. 5A is a circuit diagram illustrating an example of how to implement an amplification circuit according to an example embodiment.
FIG. 5B is a circuit diagram illustrating an example of how to implement an amplification circuit according to an example embodiment.
FIG. 6A is a circuit diagram illustrating an example of how to implement a multi-stage amplifier according to an example embodiment.
FIG. 6B is a circuit diagram illustrating an example of how to implement a multi-stage amplifier according to an example embodiment.
FIG. 6C is a circuit diagram illustrating an example of how to implement a multi-stage amplifier according to an example embodiment.
FIG. 7 is a block diagram illustrating a configuration of a transceiver according to an example embodiment.

### DETAILED DESCRIPTION

Hereinafter, various example embodiments will be described with reference to the accompanying drawings.

The expression "a first," "a second," "the first," or "the second" used in description of various example embodiments modifies various components regardless of the order or the importance but does not limit the corresponding components.

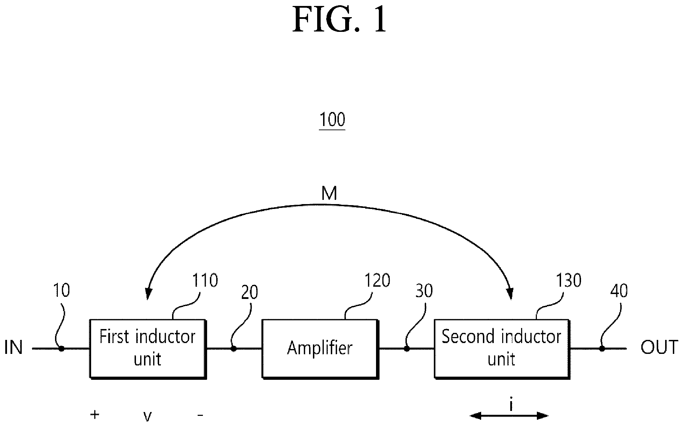

FIG. 1 is a block diagram illustrating a configuration of an amplification circuit according to an example embodiment. Referring to FIG. 1, an amplification circuit may include a first inductor unit 110, an amplifier 120, and a second inductor unit 130.

The amplifier 120 may include an input terminal 20 and an output terminal 30. The amplifier 120 may amplify a signal input through the input terminal 20 and output the amplified signal through the output terminal 30. For example, the amplifier 120 may be one of a voltage amplifier, a current amplifier, a transconductance amplifier, or a transimpedance amplifier, but example embodiments are not limited thereto.

According to an example embodiment, the amplifier 120 may be a single amplifier. The single amplifier may include a single input terminal 20 and a single output terminal 30. For example, the amplifier 120 may receive a single input signal through the input terminal 20 and output a single output signal through the output terminal 30. According to an example embodiment, the amplifier 120 may be a differential amplifier. The differential amplifier may include two input terminals 20 and two output terminals 30. For example, the amplifier 120 may receive a differential input signal through the input terminal 20 and output a differential output signal through the output terminal 30. In FIG. 1, the input terminal 20 and the output terminal 30 of the amplifier 120 are each illustrated as a single line for ease of description, which does not mean that the amplifier 120 is a single amplifier.

The first inductor unit 110 may have one end connected to the input terminal 20 of the amplifier 120. Also, the first inductor unit 110 may have the other end 10 to which an input signal IN is applied. According to example embodiments, the input signal IN may be a single signal or a differential signal. For example, when the amplifier 120 is a single amplifier, the first inductor unit 110 may include a single inductor. In this case, for example, the first inductor unit 110 may apply a single input signal IN to the input terminal 20 of the amplifier 120 through the single inductor. In some example embodiments, when the amplifier 120 is a differential amplifier, the first inductor unit 110 may include two inductors. For example, the first inductor unit 110 may apply a differential input signal IN to the input terminal 20 of the amplifier 120 through the two inductors.

The second inductor unit 130 may have one end connected to the output terminal 30 of the amplifier 120. Also, the second inductor unit 130 may have the other end 40 to which an output signal OUT of the amplification circuit 100 is output. According to example embodiments, the output signal OUT may be a single signal or a differential signal. For example, when the amplifier 120 is a single amplifier, the second inductor unit 130 may include a single inductor. In this case, for example, the second inductor unit 130 may output a single output signal OUT through the single inductor. In some example embodiments, when the amplifier 120 is a differential amplifier, the second inductor unit 130 may include two inductors. For example, the second inductor unit 130 may output a differential output signal OUT through the two inductors.

According to an example embodiment, the first inductor unit 110 and the second inductor unit 130 may be inductively coupled to each other. The term "inductive coupling" refers to coupling caused by an interaction between magnetic fields generated by currents flowing through two inductors. Due to inductive coupling, mutual inductance may be present between two inductors. Therefore, when the first inductor unit 110 and the second inductor unit 130 are inductively coupled to each other, mutual inductance M may be present between the first inductor unit 110 and the second inductor unit 130.

In an example embodiment, the first inductor unit 110 and the second inductor unit 130 may be implemented using inductance components of an interconnection connected to the input terminal 20 and an interconnection connected to the output terminal 30. For example, an interconnection corresponding to the first inductor unit 110 and an interconnection corresponding to the second inductor unit 130 may be routed to overlap each other on different layers, so that the first inductor unit 110 and the second inductor unit 130 may be inductively bonded to each other.

According to an example embodiment, the first inductor unit 110 and the second inductor unit 130 may be inductively coupled to each other such that a change in voltage of an output signal OUT (for example, an output voltage of the amplification circuit 100) is positively fed back.

The term "positive feedback" means that a change in output voltage of the amplification circuit 100 is fed back to the input terminal 20 to promote/effect a change in voltage at the input terminal 20 of the amplifier 120. Therefore, for example, when the output voltage of the amplification circuit 100 decreases, the voltage at the input terminal 20 may decrease due to the positive feedback. In this case, for example, the output voltage may further decrease. In some example embodiments, when the output voltage of the amplification circuit 100 increases, the voltage at the input terminal 20 may increase due to the positive feedback. For example, the output voltage may further increase.

This will now be described in more detail. For example, the output voltage of the amplification circuit 100 may decrease as the voltage at the input terminal 20 decreases. In this case, for example, a decrease in the voltage at the input terminal 20 may be promoted by positive feedback of the output voltage. Accordingly, the output voltage may decrease more rapidly. In addition, the output voltage of the amplification circuit 100 may increase as the voltage at the input terminal 20 increases. In this case, for example, an increase in the voltage at the input terminal 20 may be promoted by positive feedback of the output voltage. Accordingly, the output voltage may increase more rapidly.

For example, the amplifier 120 may be an inverting amplifier. In some example embodiments, when the output voltage of the amplification circuit 100 decreases, the voltage at the input terminal 20 may increase due to positive feedback. In addition, in some example embodiments, when the voltage of the amplification circuit 100 increases, the voltage at the input terminal 20 may decrease due to positive feedback.

For example, the change in the output voltage of the amplification circuit 100 may be positively fed back to the input terminal 20 based on mutual inductance M between the first inductor unit 110 and the second inductor unit 130. For example, when the output voltage of the amplification circuit 100 changes, current i flowing through the second inductor unit 130 may change accordingly. In some example embodiments, when the current i changes, a voltage v may be caused at opposite ends 10 and 20 of the first inductor unit 110 due to the mutual inductance M. Accordingly, the voltage at the input terminal 20 may change. For example, the voltage of the input terminal 20 may decrease when the voltage v increases, and may increase when the voltage v decreases.

Therefore, according to an example embodiment, when the output voltage of the amplification circuit 100 decreases, the first inductor unit 110 and the second inductor unit 130 may be inductively coupled to each other such that the voltage v increases due to a change in the current i. In some example embodiments, when the output voltage of the amplification circuit 100 increases, the first inductor unit 110 and the second inductor unit 130 may be inductively coupled to each other such that the voltage v decreases due to the change in the current i. Accordingly, a change in the output voltage of the amplification circuit 100 may be positively fed back to the input terminal 20 by the mutual inductance between the first inductor unit 110 and the second inductor unit 130.

In some example embodiments, when the change in the output voltage of the amplification circuit 100 is positively fed back, a rate at which the output voltage of the amplification circuit 100 changes depending on (or alternatively, based on) the change in the voltage at the input terminal 20 may be further increased. Accordingly, a bandwidth of the amplification circuit 100 may be improved or increased.

According to an example embodiment, the amplification circuit 100 may constitute a single stage of a multi-stage amplifier. For example, a multi-stage amplifier may include a plurality of amplifier stages such as a transconductance stage and a transimpedance stage. In this case, for example, the amplification circuit 100 may constitute at least one of the plurality of amplifier stages.

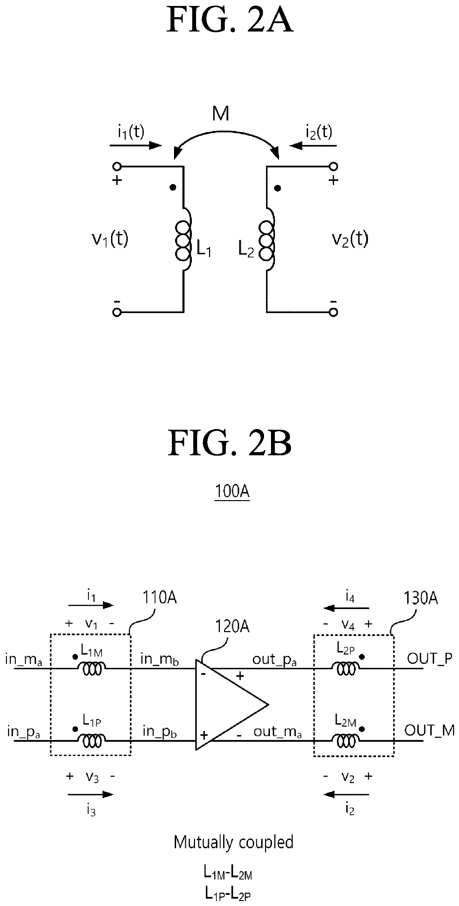

Hereinafter, the configuration and operation of an amplification circuit according to an example embodiment will be described in detail with reference to FIGS. 2A and 2B.

FIG. 2A is a diagram illustrating a coupling effect between two inductors caused by mutual inductance. FIG. 2A illustrates a coupling effect caused by mutual inductance relevant to example embodiments. In FIG. 2A, M represents a mutual inductance value between two inductors L₁ and L₂ inductively coupled to each other, and M is a positive number.

Referring to FIG. 2A, when the amount of change in current flowing in a direction i₂ increases, a voltage vi may increase due to the mutual inductance M. In contrast, when the amount of change in the current flowing in the direction i₂ decreases, the voltage vi may decrease due to the mutual inductance M.

FIG. 2B is a circuit diagram illustrating an example of how to implement an amplification circuit according to an example embodiment. Referring to FIG. 2B, an amplification circuit 100A may include a first inductor unit 110A, an amplifier 120A, and a second inductor unit 130A.

The amplifier 120A may be a differential amplifier receiving differential input signals in_m_{b} and in_p_{b} and outputting differential output signals out_pₐ and out_mₐ. The differential input signal may include a first signal in_m_{b} and a second signal in_p_{b} having opposite phases. Accordingly, the amplifier 120A may include a first input terminal (-) for receiving the first signal in_m_{b} and a second input terminal (+) for receiving the second signal in_p_{b}. The differential output signal may include a third signal out_mₐ obtained by amplifying the first signal in_m_{b} and a fourth signal out_pₐ obtained by amplifying the second signal in_p_{b}. The third signal out_mₐ and the fourth signal out_pₐ may have opposite phases. Accordingly, the amplifier 120A may include a first output terminal (-) for outputting the third signal out_mₐ and a second output terminal (+) for outputting the fourth signal out_pₐ.

The first inductor unit 110A may include a first inductor L_{1M} and a second inductor L_{1P}. The first inductor L_{1M} may have one end connected to the first input terminal (-) of the amplifier 120A, and may receive an input signal in_mₐ through the other end thereof. The second inductor L_{1P} may have one end connected to the second input terminal (+) of the amplifier 120A, and may receive an input signal in_pₐ through the other end thereof. For example, the input signal in_mₐ and the input signal in_pₐ may be differential signals having opposite phases. The other end of the first inductor L_{1M} may be the first input terminal of the amplification circuit 100A, and the other end of the second inductor L_{1P} may be the second input terminal of the amplification circuit 100A.

The second inductor unit 130A may include a third inductor L_{2M} and a fourth inductor L_{2P}. The third inductor L_{2M} may have one end connected to the first output terminal (-) of the amplifier 120A, and may output an output signal OUT_M through the other terminal thereof. The fourth inductor L2P may have one end connected to the second output terminal (+) of the amplifier 120A, and may output an output signal OUT_P through the other terminal. For example, the output signal OUT_M and the output signal OUT_P may be differential signals having opposite phases. The other end of the fourth inductor L2P may be the first output end of the amplification circuit 100A, and the other end of the third inductor L2M may be the second output end of the amplification circuit 100A.

As described above, the first inductor unit 110A and the second inductor unit 130A may be inductively coupled to each other. In this case, according to an example embodiment, the first inductor L_{1M} and the third inductor L_{2M} may be inductively coupled to each other, and the second inductor L_{1P} and the fourth inductor L_{2P} may be inductively coupled to each other. For example, mutual inductance may be present between the first inductor L_{1M} and the third inductor L_{2M}, and mutual inductance may be present between the second inductor L_{1P} and the fourth inductor L_{2P}.

For example, when the voltage of the input signal in_pₐ is increased and the voltage of the input signal in_mₐ is decreased, the voltage of the output signal OUT_P may be increased and the voltage of the output signal OUT_M be decreased by the amplifier 120A.

In some example embodiments, when the voltage of the output signal OUT_M decreases, positive charges may be discharged in the direction i₂ to increase the current flowing in the direction i₂. For example, the voltage vi across the first inductor L_{1M} may increase due to a coupling effect caused by the mutual inductance present between the first inductor L_{1M} and the third inductor L_{2M}. In some example embodiments, when the voltage vi increases, a voltage of the first signal in_m_{b} applied to the first input terminal (-) of the amplifier 120A may decrease. As the voltage of the first signal in_m_{b} decreases, the voltage of the output signal OUT_M may decrease more rapidly through a gain of the amplifier 120A.

In some example embodiments, when the voltage of the output signal OUT_P increases, positive charges may be discharged in a direction opposite to i₄, to decrease current flowing in the direction i₄. For example, a voltage v₃ across the second inductor L_{1P} may decrease due to a coupling effect caused by the mutual inductance present between the second inductor L_{1P} and the fourth inductor L_{2P}. In some example embodiments, when the voltage v₃ decreases, the voltage of the second signal in_p_{b} applied to the second input terminal (+) of the amplifier 120A may increase. As the voltage of the second signal in_p_{b} increases, the voltage of the output signal OUT_P may increase more rapidly through the gain of the amplifier 120A.

While the case in which the voltage of the input signal in_pₐ increases and the voltage of the input signal in_mₐ decreases has been described, an operation of the amplification 100A in an opposite case, for example, a case in which the voltage of the input signal in_pₐ decreases and the input signal in_mₐ increases may also be understood to be similar.

As described above, according to an example embodiment, a rate at which the voltage of the output signal OUT_M and the output signal OUT_P change depending on (or alternatively, based on) a change in the voltage of the input signal in_mₐ and the input signal in_pₐ may be further increased and a bandwidth of the amplification circuit 100A may be increased.

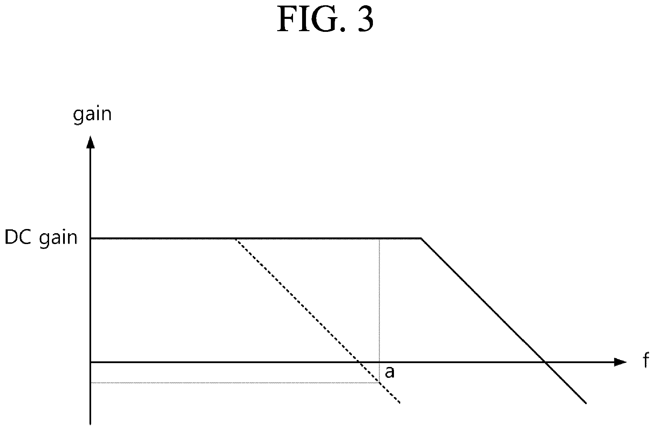

FIG. 3 is a diagram illustrating a bandwidth improvement effect of an amplification circuit according to an example embodiment. In FIG. 3, a dashed line represents a bandwidth of an amplification circuit, to which a general bandwidth extension technique is applied, and a solid line represents a bandwidth of an amplification circuit according to example embodiments.

In FIG. 3, it can be seen that the bandwidth of the amplification circuit according to example embodiments is significantly larger than the bandwidth of the amplification circuit to which the general technique is applied. Therefore, for example, in the case of the general technique, the gain of the amplifier is significantly reduced even when a frequency of an input signal includes a component of frequency a (or alternatively, the frequency of the input signal is only a). For example, a rate of change of an output signal may be significantly decreased compared with a rate of change of an input signal to prevent (or alternatively, reduce a chance of) the amplification circuit from operating abnormally. However, according to example embodiments, the gain of the amplifier may be maintained for an input signal having the same frequency. Accordingly, a normal high-speed operation may be performed even for an input signal having a high frequency band compared to general technique.

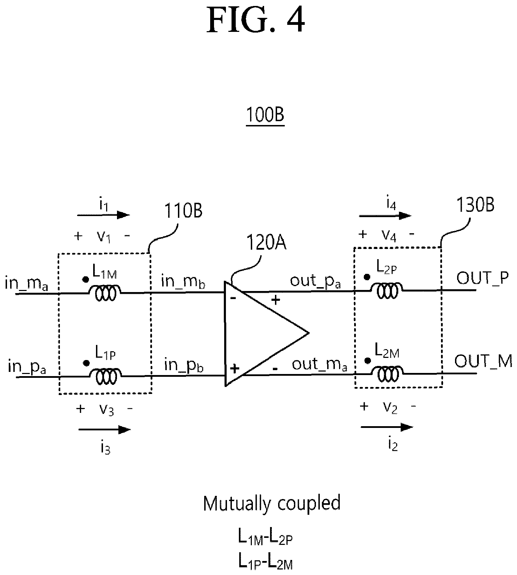

FIG. 4 is a circuit diagram illustrating an example of how to implement an amplification circuit according to an example embodiment.

Referring to FIG. 4, an amplification circuit 100B may include a first inductor unit 110B, an amplifier 120A, and a second inductor unit 130B.

The amplification circuit 100B of FIG. 4 has the same configuration as the amplification circuit 100A of FIG. 2B. However, in the sense that a first inductor L_{1M} and a fourth inductor L_{2P} are inductively coupled to each other and a second inductor L_{1P} and a third inductor L_{2M} are inductively coupled to each other, the amplification circuit 100B of FIG. 4 is different from the amplification circuit 100A of FIG. 2B. Therefore, locations of dots of the third inductor L_{2M} and the fourth inductor L_{2P} and voltages v₂ and v₄ and currents i₂ and i₄ related to the third inductor L_{2M} and the fourth inductor L_{2P} are illustrated differently from those of the amplification circuit 100A.

Hereinafter, redundant descriptions of the same configuration as the amplification circuit 100A will be omitted, and the operation of the amplification circuit 100B will be described while focusing on the differences.

As described above, in the amplification circuit 100B, the first inductor L_{1M} and the fourth inductor L_{2P} are inductively coupled to each other and the second inductor L_{1P} and the third inductor L_{2M} are inductively coupled to each other. Therefore, mutual inductance may be present between the first inductor L_{1M} and the fourth inductor L_{2P}, and mutual inductance may be present between the second inductor L_{1P} and the third inductor L_{2M}.

For example, when a voltage of the input signal in_pₐ increases and a voltage of the input signal in_mₐ decreases, a voltage of the output signal OUT_P may be increased by the amplifier 120A and a voltage of the output signal OUT_M may be decreased by the amplifier 120A.

In some example embodiments, when the voltage of the output signal OUT_M decreases, positive charges may be discharged in a direction opposite to i₂ to decrease current flowing in the direction i₂. For example, a voltage v₃ across the second inductor L_{1P} may decrease due to a coupling effect caused by the mutual inductance present between the second inductor L_{1P} and the third inductor L_{2M}. In some example embodiments, when the voltage v₃ decreases, a voltage of the second signal in_p_{b} applied to a second input terminal (+) of the amplifier 120A may increase. As the voltage of the second signal in_p_{b} increases, the voltage of the output signal OUT_P may increase more rapidly through a gain of the amplifier 120A.

In some example embodiments, when the voltage of the output signal OUT_P increases, positive charges may be discharged in a direction i₄ to increase current flowing in the direction i₄. For example, a voltage vi across the first inductor L_{1M} may increase due to a coupling effect caused by the mutual inductance present between the first inductor L_{1M} and the fourth inductor L_{2P}. In some example embodiments, when the voltage vi increases, a voltage of the first signal in_m_{b} applied to the first input terminal (-) of the amplifier 120A may decrease. As the voltage of the first signal in_m_{b} decreases, the voltage of the output signal OUT_M may decrease more rapidly through the gain of the amplifier 120A.

To sum up the above, when the voltage of the output signal OUT_M decreases, the voltage of the second signal in_p_{b} applied to the second input terminal (+) of the amplifier 120A may increase. In addition, when the output signal OUT_P increases, the voltage of the first signal in_m_{b} applied to the first input terminal (-) of the amplifier 120A may decrease. For example, the output signal OUT_M and the output signal OUT_P are differential signals having opposite phases, so that the voltage of the output signal OUT_P increases when the voltage of the output signal OUT_M decreases and the voltage of the output signal OUT_M decreases when the voltage of the output signal OUT_P increases.

Accordingly, in some example embodiments, the amplification circuit 100B may also be configured to receive positive feedback. For example, when the voltage of the output signal OUT_M decreases, the voltage of the first signal in_m_{b} applied to the first input terminal (-) of the amplifier 120A decreases based on the increased output signal OUT_P, so that the voltage of the output signal OUT_M may decrease more rapidly through the gain of the amplifier 120A. Additionally, when the voltage of the output signal OUT_P increases, the voltage of the second signal in_p_{b} applied to the second input terminal (+) of the amplifier (120A) increases based on the decreased voltage of the output signal OUT_M, so that the voltage of the output signal OUT_P may increase more rapidly through the gain of the amplifier 120A.

While the case in which the voltage of the input signal in_pₐ increases and the voltage of the input signal in_mₐ decreases has been described, an operation of the amplification 100B in an opposite case, for example, a case in which the voltage of the input signal in_pₐ decreases and the input signal in_ma increases may also be understood to be similar.

As described above, according to an example embodiment, a rate at which the voltage of the output signal OUT_M and the output signal OUT_P change depending on (or alternatively, based on) a change in the voltage of the input signal in_ma and the input signal in_pa may be further increased. As a result, a bandwidth of the amplification circuit 100B may increase.

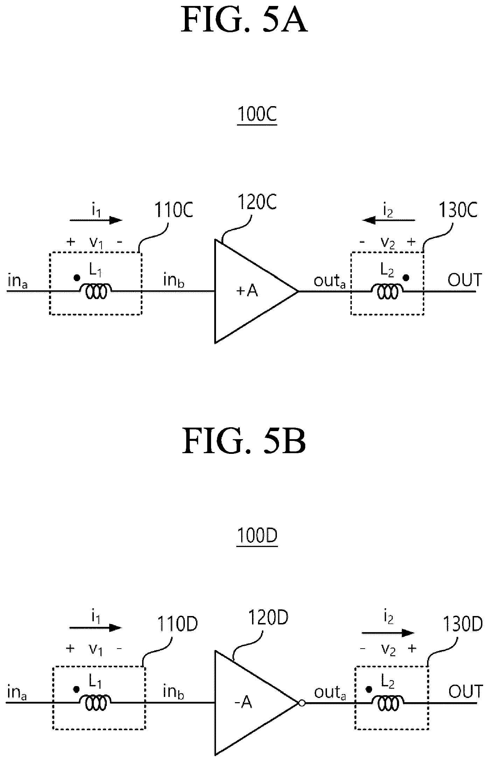

FIG. 5A is a circuit diagram illustrating an example of how to implement an amplification circuit according to an example embodiment.

Referring to FIG. 5A, an amplification circuit 100C may include a first inductor unit 110C, an amplifier 120C, and a second inductor unit 130C.

The amplifier 120C may be a single amplifier receiving a single input signal in_{b} and outputs a single output signal outₐ. For example, the amplifier 120C may be a non-inverting amplifier. The amplifier 120C may include a single input terminal for receiving an input signal in_{b} and a single output terminal for outputting an output signal outₐ.

The first inductor unit 110C may include a first inductor L₁. The first inductor L₁ may have one end, connected to the input terminal of the amplifier 120C, and the other end through which an input signal inₐ is received.

The second inductor unit 130C may include a second inductor L₂. The second inductor L₂ may have one end, connected to the output terminal of the amplifier 120C, and the other end through which an output signal OUT of the amplification circuit 100C is output.

According to an example embodiment, the first inductor L₁ and the second inductor L₂ may be inductively coupled to each other. For example, mutual inductance may be present between the first inductor L₁ and the second inductor L₂.

For example, when the voltage of the input signal inₐ decreases, a voltage of the output signal OUT may be decreased by the amplifier 120C. In some example embodiments, when the voltage of the output signal OUT decreases, positive charges may be discharged in a direction i₂ to increase current flowing in a direction i₂. For example, a voltage vi across the first inductor L₁ may increase due to a coupling effect caused by mutual inductance present between the first inductor L₁ and the second inductor L₂. In some example embodiments, when the voltage vi increases, a voltage of the signal in_{b} applied to the input terminal of the amplifier 120C may decrease. As the voltage of the signal in_{b} decreases, the voltage of the output signal OUT may decrease more rapidly through a gain of the amplifier 120C.

In some example embodiments, when the voltage of the input signal inₐ increases, the voltage of the output signal OUT may be increased by the amplifier 120C. In some example embodiments, when the voltage of the output signal OUT increases, positive charges may be discharged in a direction opposite to i₂ to decrease current flowing in the direction i₂. For example, the voltage vi across the first inductor L1 may decrease due to a coupling effect caused by mutual inductance present between the first inductor L₁ and the second inductor L₂. In some example embodiments, when the voltage vi decreases, a voltage of the signal in_{b} applied to the input terminal of the amplifier 120C may increase. As the voltage of the signal in_{b} increases, the voltage of the output signal OUT may increase more rapidly through the gain of the amplifier 120C.

As described above, according to an example embodiment, a rate at which the voltage of the output signal OUT changes depending on (or alternatively, based on) a voltage change of the input signal inₐ may be further increased, and a bandwidth of the amplification circuit 100C may be increased.

FIG. 5B is a circuit diagram illustrating an example of how to implement an amplification circuit according to an example embodiment. Referring to FIG. 5B, an amplification circuit 100D may include a first inductor unit 110D, an amplifier 120D, and a second inductor unit 130D.

The amplifier 120D may be a single amplifier receiving a single input signal in_{b} and outputs a single output signal outₐ. For example, the amplifier 120D may be an inverting amplifier. The amplifier 120D may include a single input terminal for receiving an input signal in_{b} and a single output terminal for outputting an output signal outₐ.

The first inductor unit 110D may include a first inductor L₁. The first inductor L₁ may have one end, connected to the input terminal of the amplifier 120D, and the other end through which an input signal inₐ is received.

The second inductor unit 130D may include a second inductor L₂. The second inductor L₂ may have one end, connected to the output terminal of the amplifier 120D, and the other end through which an output signal OUT of the amplification circuit 100D is output.

According to an example embodiment, the first inductor L₁ and the second inductor L₂ may be inductively coupled to each other. For example, mutual inductance may be present between the first inductor L₁ and the second inductor L₂.

For example, when the voltage of the input signal inₐ decreases, a voltage of the output signal OUT may increase because the amplifier 120D is an inverting amplifier. In some example embodiments, when the voltage of the output signal OUT increases, positive charges may be discharged in a direction i2 to increase current flowing in a direction i₂. For example, a voltage vi across the first inductor L₁ may increase due to a coupling effect caused by mutual inductance present between the first inductor L₁ and the second inductor L₂. In some example embodiments, when the voltage vi increases, a voltage of the signal in_{b} applied to the input terminal of the amplifier 120D may decrease. Since the amplifier 120D is an inverting amplifier, as the voltage of the signal in_{b} decreases, the voltage of the output signal OUT may increase more rapidly through a gain of the amplifier 120D.

In some example embodiments, when the voltage of the input signal inₐ increases, the voltage of the output signal OUT may decrease because the amplifier 120D is an inverting amplifier. In some example embodiments, when the voltage of the output signal OUT decreases, positive charges may be discharged in a direction opposite to i₂ to decrease current flowing in the direction i₂. For example, the voltage vi across the first inductor L1 may decrease due to a coupling effect caused by mutual inductance present between the first inductor L₁ and the second inductor L₂. In some example embodiments, when the voltage vi decreases, a voltage of the signal in_{b} applied to the input terminal of the amplifier 120D may increase. Since the amplifier 120D is an inverting amplifier, as the voltage of the signal in_{b} increases, the voltage of the output signal OUT may decrease more rapidly through the gain of the amplifier 120D.

As described above, according to an example embodiment, a rate at which the voltage of the output signal OUT changes depending on (or alternatively, based on) a voltage change of the input signal inₐ may be further increased, and a bandwidth of the amplification circuit 100D may be increased.

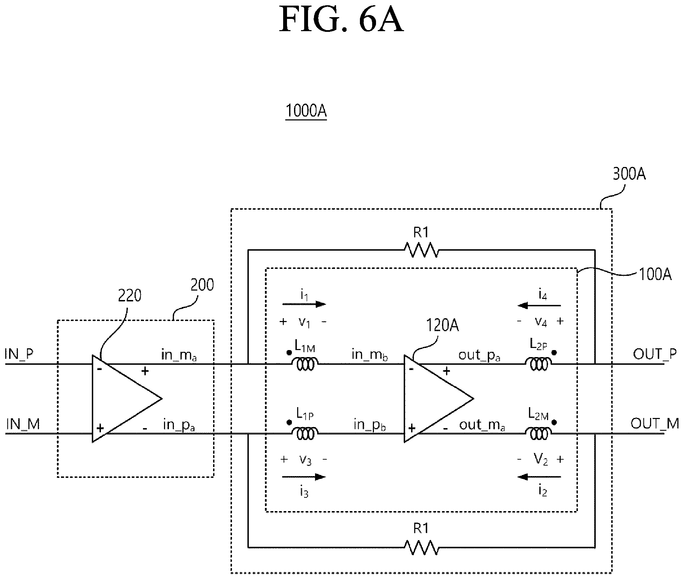

FIG. 6A is a circuit diagram illustrating an example of how to implement a multi-stage amplifier according to an example embodiment. A multi-stage amplifier is an amplifier including multiple single-stage amplifiers connected in cascade. Each of the amplifiers constituting the multi-stage amplifier may be referred to as a "stage" or an "amplification stage." According to an example embodiment, each of the above-described amplification circuits 100, 100A, 100B, 100C, and 100D may constitute at least one stage among a plurality of stages included in a multi-stage amplifier.

For example, referring to FIG. 6A, a multi-stage amplifier 1000A may include a gm stage 200 and a TIA stage 300A. The gm stage refers to a transconductance stage, and the TIA stage refers to a transimpedance amplifier stage.

The gm stage 200 may be an amplification stage receiving a voltage as an input and current as an output. For example, the gm stage 200 may include a differential amplifier 220 receiving differential input signals IN_P and IN_M and outputting differential output signals in_mₐ and in_pₐ.

The TIA stage 300A may be an amplification stage receiving current as an input and a voltage as an output. For example, the TIA stage 300A may include the amplification circuit 100A described above in FIG. 2B and resistors R1. According to an example embodiment, a first resistor R1 may be connected between a first input terminal and a first output terminal of the amplification circuit 100A and a second resistor R1 may be connected between a second input terminal and a second output terminal of the amplification circuit 100A.

The output of the gm stage 200 may be the input of the TIA stage 300A. For example, the output signal in_mₐ of the gm stage 200 may be input to the TIA stage 300A through the first input terminal of the amplification circuit 100A, and the output signal in_pₐ of the gm stage 200 may be input to the TIA terminal 300A through the second input terminal 100A of the amplification circuit 100A. Accordingly, the TIA stage 300A may respectively receive the differential input signals in_mₐ and in_pₐ through the first and second input terminals of the amplification circuit 100A, and may respectively output differential output signals OUT_P and OUT_M through the first and second output terminals of the amplification circuit 100A.

For example, when a voltage of IN_P increases and a voltage of IN_M decreases, OUT_P may be increased and OUT_M may be decreased by an amplifier 220 and an amplifier 120A. In this case, for example, OUT_P may be increased more rapidly and OUT_M may be decreased more rapidly through an operation of the amplification circuit 100A, as described above in FIG. 2B.

In some example embodiments, in the same way that OUT_P is decreased and OUT_M is increased as the voltage of IN_P decreases and the voltage of IN_M increases, the output voltage OUT_P may decrease more rapidly and the output voltage OUT_M may increase more rapidly through the operation of the amplification circuit 100A.

As described above, according to an example embodiment, a speed at which the voltages of OUT_P and OUT_M change depending on (or alternatively, based on) the voltage change of IN_P and IN_M may be further increased. Thus, a bandwidth of the multi-stage amplifier 1000A may be increased.

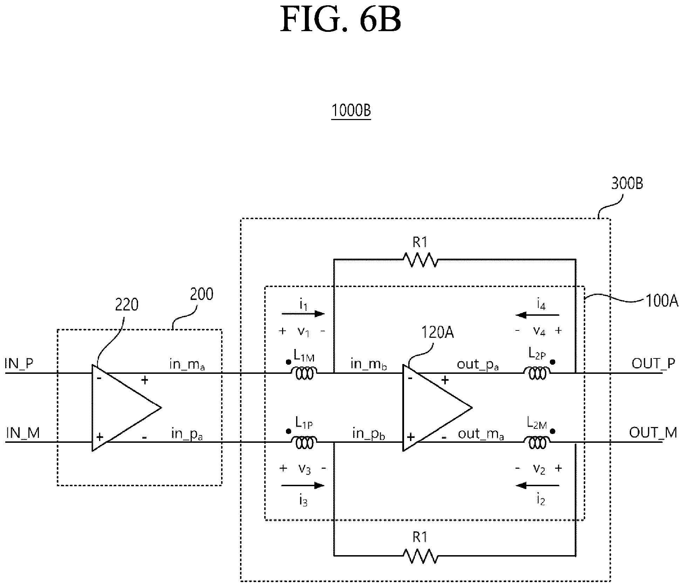

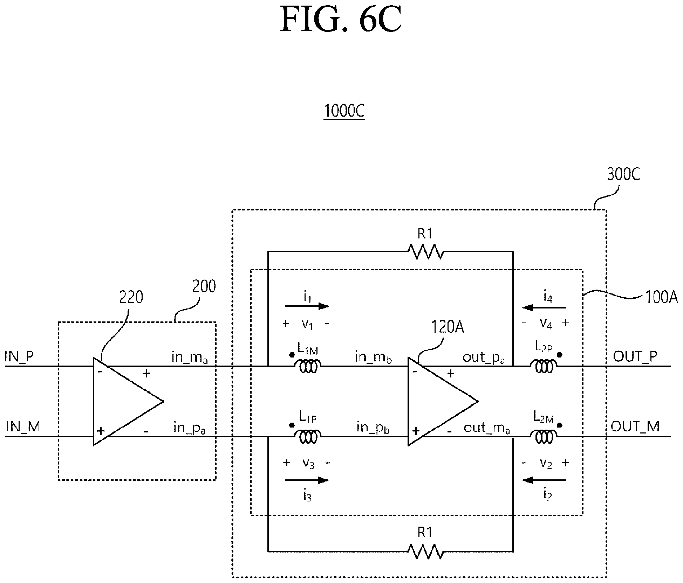

FIGS. 6B and 6C are circuit diagrams illustrating examples of how to implement multi-stage amplifiers according to various example embodiments, respectively. Referring to FIG. 6B, a multi-stage amplifier 1000B may include a gm stage 200 and a TIA stage 300B. For example, the TIA stage 300B may include resistors R1, respectively connected between a first input terminal (-) of an amplifier 120A and a first output terminal of an amplification circuit 100A and between a second input terminal (+) of the amplifier 120A and a second output terminal of the amplification circuit 100A.

The multi-stage amplifier 1000B has the same configuration as the multi-stage amplifier 1000A of FIG. 6A, except for a node to which the resistors R1 are connected (or alternatively, except for only a node to which the resistors R1 are connected). An operation of the multi-stage amplifier 1000B is the same as the operation of the amplifier 1000A of FIG. 6A, so that redundant descriptions will be omitted.

Referring to FIG. 6C, a multi-stage amplifier 1000C may include a gm stage 200 and a TIA stage 300C. The TIA stage 300C may include resistors R1, respectively connected between a first input terminal of an amplification circuit 100A and a second output terminal (+) of an amplifier 120A and between a second input terminal of the amplification circuit 100A and a first output terminal (-) of the amplifier 120A.

The multi-stage amplifier 100C also has the same configuration as the multi-stage amplifier 1000A of FIG. 6A, except for a node to which resistors R1 are connected. An operation of the multi-stage amplifier 100C is the same as the operation of the amplifier 1000A of FIG. 6A, so that redundant descriptions will be omitted.

In FIGS. 6A to 6C, examples of how to implement the TIA stage of the multi-stage amplifier using the amplification circuit 100A of FIG. 2B have been described, but example embodiments are not limited thereto. According to example embodiment, at least one of the gm stage and the TIA stage may be implemented using the amplification circuit 100A of FIG. 2B or the amplification circuit 100B of FIG. 4. For example, the gm stage of the multi-stage amplifier may be implemented using the amplification circuits 100A and 100B, and both the gm stage and the TIA stage of the multi-stage amplifier may be implemented using the amplification circuits 100A and 100B.

According to an example embodiment, the above-described amplification circuits 100, 100A, 100B, 100C, and 100D may be included in transceivers of various wired and wireless communication modules. For example, the amplification circuits 100, 100A, 100B, 100C, and 100D may constitute an amplifier or a stage of the amplifier such as a power amplifier (PA), a gain peaking amplifier (GPA), or a low noise amplifier (LNA) included in a high-speed wired SerDes transceiver or a high-speed wireless communication transceiver.

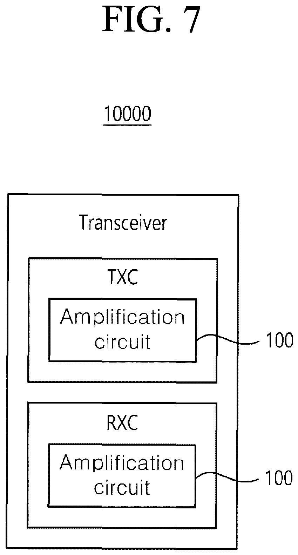

FIG. 7 is a block diagram illustrating a configuration of a transceiver according to an example embodiment. Referring to FIG. 7, a transceiver 10000 may include a transmit circuit TXC, transmitting a signal, and a receive circuit RXC receiving a signal. For example, when the transceiver 10000 is a transceiver for wired communication such as Ethernet, the transceiver may transmit and receive signals through the transmit circuit TXC and the receive circuit RXC and at least one wired channel. Additionally, when the transceiver 10000 is a transceiver for wireless communication such as wireless LAN or mobile communication, the transceiver may transmit and receive signals through the transmit circuit TXC and the receive circuit RXC and at least one wireless channel.

The transmit circuit TXC may include various amplifiers such as a drive amplifier, a GPA, a PA, or the like, and the receive circuit RXC may include various amplifiers such as an intermediate frequency (IF) amplifier, an LNA, or the like. For example, according to an example embodiment, at least one of the various amplifiers included in the transmit circuit TXC and the receive circuit RXC may be implemented to include the above-described amplification circuit 100.

While various example embodiments related to an amplifier for signal amplification have been described, example embodiments are not limited thereto. Example embodiments may be applied to all circuits, requiring (or using) bandwidth extension for a high-speed operation, such as a buffer, a clock distribution circuit, or the like. For example, even in the case of devices other than amplifiers, the bandwidth may be extended by placing inductors, inductively coupled to each other, at an input terminal and an output terminal, respectively.

As an example, in the above-described example embodiments, a buffer may be used instead of the amplifiers 120, 120A, 120C, and 120D. In other examples, each of the amplifiers described above may be an amplifier configured to function as a buffer, such as a unity gain amplifier. In these examples, each of the amplification circuits 100, 100A, 100B, 100C, and 100D may be a buffer circuit. Such a buffer circuit includes a first inductor unit 110 and a second inductor unit 130 which are inductively coupled to each other, and thus may have an increased bandwidth and perform a high-speed operation due to a coupling effect caused by the above-described mutual inductance, as compared to a typical buffer circuit.

Locations of dots, directions of voltages, and directions of currents of inductors illustrated in the accompanying drawings are only examples for ease of description, and example embodiments are not limited thereto. For example, in the case in which a first inductor and a second inductor inductively coupled to have mutual inductance are respectively connected to an input terminal and an output terminal of an amplifier (or a buffer) and an output voltage is positively fed back by the mutual inductance, the case may be included in example embodiments even when the locations of dots, the directions of voltages and currents, a sign of mutual inductance M are changed.

According to the above-described various example embodiments, an amplification circuit, a multi-stage amplifier, and an amplifier having a bandwidth increased based on a coupling effect occurring due to inductive coupling of inductors may be provided.

As set forth above, according to example embodiments, an amplification circuit, a multi-stage amplifier, and an amplifier having a bandwidth increased based on a coupling effect occurring due to inductive coupling of inductors may be provided.

While example embodiments have been shown and described above, it will be apparent to those skilled in the art that modifications and variations could be made without departing from the scope of the present inventive concepts as defined by the appended claims.
Further Embodiments are set out in the following clauses:
Clause 1. An amplification circuit comprising:
   an amplifier including an input terminal and an output terminal;
   a first inductor unit connected to the input terminal; and
   a second inductor unit connected to the output terminal,
   wherein the first inductor unit and the second inductor unit are inductively coupled to each other so that a change in output voltage of the amplification circuit is positively fed back.
Clause 2. The amplification circuit of clause 1, wherein
   the first inductor unit and the second inductor unit are inductively coupled to each other so that a change in voltage at the input terminal is promoted by the change in the output voltage of the amplification circuit.
Clause 3. The amplification circuit of clause 1 or clause 2, wherein
   the first inductor unit and the second inductor unit are inductively coupled to each other so that mutual inductance is present between the first inductor unit and the second inductor unit, and
   the change in the output voltage of the amplification circuit is positively fed back based on the mutual inductance.
Clause 4. The amplification circuit of any preceding clause, wherein
   the input terminal comprises a first input terminal and a second input terminal,
   the output terminal comprises a first output terminal corresponding to the first input terminal and a second output terminal corresponding to the second input terminal,
   the first inductor unit includes
      a first inductor having one end, connected to the first input terminal, and another end through which a first input signal is received; and
      a second inductor having one end, connected to the second input terminal, and another end through which a second input signal, having a phase opposite to a phase of the first input signal, is received, and
   the second inductor unit includes
      a third inductor having one end, connected to the first output terminal, and another end through which a first output voltage of the amplification circuit is output; and
      a fourth inductor having one end, connected to the second output terminal, and another end through which a second output voltage of the amplification circuit is output.
Clause 5. The amplification circuit of clause 4, wherein
   the first output voltage is output through the another end of the third inductor and the second output voltage is output through the another end of the fourth inductor,
   the first output voltage and the second output voltage are differential signals having opposite phases,
   a voltage at the first input terminal decreases when the first output voltage decreases and increases when the first output voltage increases, and
   a voltage at the second input terminal increases when the second output voltage increases and decreases when the second output voltage decreases.
Clause 6. The amplification circuit of clause 4 or clause 5, wherein
   the first inductor and the third inductor are inductively coupled to each other to have first mutual inductance, and
   the second inductor and the fourth inductor are inductively coupled to each other to have second mutual inductance.
Clause 7. The amplification circuit of clause 6, wherein
   the first inductor and the third inductor are inductively coupled to each other so that a voltage at the first input terminal is decreased by the first mutual inductance based on a decreased first output voltage, and the voltage at the first input terminal is increased by the first mutual inductance based on an increased first output voltage, and
   the second inductor and the fourth inductor are inductively coupled to each other so that a voltage at the second input terminal is increased by the second mutual inductance based on an increased second output voltage, and the voltage at the second input terminal is decreased by the second mutual inductance based on a decreased second output voltage.
Clause 8. The amplification circuit of clause 4 or clause 5, wherein
   the first inductor and the fourth inductor are inductively coupled to each other to have first mutual inductance, and
   the second inductor and the third inductor are inductively coupled to each other to have second mutual inductance.
Clause 9. The amplification circuit of clause 8, wherein
   the first inductor and the fourth inductor are inductively coupled to each other so that a voltage at the first input terminal is decreased by the first mutual inductance based on an increased second output voltage when the first output voltage decreases, and the voltage at the first input terminal is increased by the first mutual inductance based on the second output voltage when the first output voltage is increased, and
   the second inductor and the third inductor are inductively coupled to each other so that a voltage at the second input terminal is increased by the second mutual inductance based on the first output voltage when the second output voltage is increased, and the voltage at the second input terminal is decreased by the second mutual inductance based on the increased first output voltage when the second output voltage is decreased.
Clause 10. The amplification circuit of any one of clauses 1 - 3, wherein
   the first inductor unit comprises a first inductor having one end, connected to the input terminal, and another end through which an input signal is received,
   the second inductor unit comprises a second inductor having one end, connected to the output terminal, and another end through which the output voltage of the amplification circuit is output, and
   the first inductor and the second inductor are inductively coupled to each other to have mutual inductance.
Clause 11. The amplification circuit of clause 10, wherein
   the amplifier is a non-inverting amplifier, and
   a voltage at the input terminal is increased by the mutual inductance based on an increased output voltage of the amplification circuit, and the voltage at the input terminal is decreased by the mutual inductance based on a decreased output voltage of the amplification circuit.
Clause 12. The amplification circuit of clause 10, wherein
   the amplifier is an inverting amplifier, and
   a voltage at the input terminal is decreased by the mutual inductance based on an increased output voltage of the amplification circuit, and the voltage at the input terminal is increased by the mutual inductance based on a decreased output voltage of the amplification circuit.
Clause 13. The amplification circuit of clause 1, wherein
   the amplifier is a buffer.
Clause 14. The amplification circuit of clause 1, wherein
   the amplification circuit constitute at least one stage, among a plurality of stages included in a multi-stage amplifier.
Clause 15. A multi-stage amplifier comprising:
   a plurality of amplification stages,
   wherein at least one of the plurality of amplification stages includes
      an amplifier including an input terminal and an output terminal;
      a first inductor unit connected to the input terminal; and
      a second inductor unit connected to the output terminal, and
   the first inductor unit and the second inductor unit are inductively coupled to each other so that a change in output voltage of a corresponding amplification stage is positively fed back.

## Claims

1. An amplification circuit comprising:
an amplifier including an input terminal and an output terminal;
a first inductor unit connected to the input terminal; and
a second inductor unit connected to the output terminal,
wherein the first inductor unit and the second inductor unit are inductively coupled to each other so that a change in output voltage of the amplification circuit is positively fed back.

2. The amplification circuit of claim 1, wherein
the first inductor unit and the second inductor unit are inductively coupled to each other so that a change in voltage at the input terminal is effected by the change in the output voltage of the amplification circuit.

3. The amplification circuit of claim 1 or claim 2, wherein
the first inductor unit and the second inductor unit are inductively coupled to each other so that mutual inductance is present between the first inductor unit and the second inductor unit, and
the change in the output voltage of the amplification circuit is positively fed back based on the mutual inductance.

4. The amplification circuit of any preceding claim, wherein
the input terminal comprises a first input terminal and a second input terminal,
the output terminal comprises a first output terminal corresponding to the first input terminal and a second output terminal corresponding to the second input terminal,
the first inductor unit includes
a first inductor having one end, connected to the first input terminal, and another end through which a first input signal is received; and
a second inductor having one end, connected to the second input terminal, and another end configured to receive a second input signal, the second input signal having a phase opposite to a phase of the first input signal, and
the second inductor unit includes
a third inductor having one end, connected to the first output terminal, and another end configured to output a first output voltage of the amplification circuit; and
a fourth inductor having one end, connected to the second output terminal, and another end configured to output a second output voltage of the amplification circuit.

5. The amplification circuit of claim 4, the amplification circuit configured such that:
the first output voltage is output through the another end of the third inductor and the second output voltage is output through the another end of the fourth inductor,
the first output voltage and the second output voltage are differential signals having opposite phases,
a voltage at the first input terminal decreases when the first output voltage decreases and increases when the first output voltage increases, and
a voltage at the second input terminal increases when the second output voltage increases and decreases when the second output voltage decreases.

6. The amplification circuit of claim 4 or claim 5, wherein
the first inductor and the third inductor are inductively coupled to each other to have first mutual inductance, and
the second inductor and the fourth inductor are inductively coupled to each other to have second mutual inductance.

7. The amplification circuit of claim 6, wherein
the first inductor and the third inductor are inductively coupled to each other so that a voltage at the first input terminal is decreased by the first mutual inductance based on a decreased first output voltage, and so that the voltage at the first input terminal is increased by the first mutual inductance based on an increased first output voltage, and
the second inductor and the fourth inductor are inductively coupled to each other so that a voltage at the second input terminal is increased by the second mutual inductance based on an increased second output voltage, and so that the voltage at the second input terminal is decreased by the second mutual inductance based on a decreased second output voltage.

8. The amplification circuit of claim 4 or claim 5, wherein
the first inductor and the fourth inductor are inductively coupled to each other to have first mutual inductance, and
the second inductor and the third inductor are inductively coupled to each other to have second mutual inductance.

9. The amplification circuit of claim 8, wherein
the first inductor and the fourth inductor are inductively coupled to each other so that a voltage at the first input terminal is decreased by the first mutual inductance based on an increased second output voltage when the first output voltage decreases, and so that the voltage at the first input terminal is increased by the first mutual inductance based on the second output voltage when the first output voltage is increased, and
the second inductor and the third inductor are inductively coupled to each other so that a voltage at the second input terminal is increased by the second mutual inductance based on the first output voltage when the second output voltage is increased, and so that the voltage at the second input terminal is decreased by the second mutual inductance based on the increased first output voltage when the second output voltage is decreased.

10. The amplification circuit of any one of claims 1 - 3, wherein
the first inductor unit comprises a first inductor having one end, connected to the input terminal, and another end through which an input signal is received,
the second inductor unit comprises a second inductor having one end, connected to the output terminal, and another end through which the output voltage of the amplification circuit is output, and
the first inductor and the second inductor are inductively coupled to each other to have mutual inductance.

11. The amplification circuit of claim 10, wherein
the amplifier is a non-inverting amplifier, and
the amplification circuit is configured such that a voltage at the input terminal is increased by the mutual inductance based on an increased output voltage of the amplification circuit, and such that the voltage at the input terminal is decreased by the mutual inductance based on a decreased output voltage of the amplification circuit.

12. The amplification circuit of claim 10, wherein
the amplifier is an inverting amplifier, and
the amplification circuit is configured such that a voltage at the input terminal is decreased by the mutual inductance based on an increased output voltage of the amplification circuit, and such that the voltage at the input terminal is increased by the mutual inductance based on a decreased output voltage of the amplification circuit.

13. The amplification circuit of claim 1, wherein
the amplifier is a buffer.

14. The amplification circuit of any preceding claim, wherein
the amplification circuit is configured as at least one stage among a plurality of stages included in a multi-stage amplifier.

15. A multi-stage amplifier comprising:
a plurality of amplification stages,
wherein at least one of the plurality of amplification stages comprises an amplification circuit according to any preceding claim.
